# EUROPEAN PATENT APPLICATION

(11) **EP 4 746 627 A1**
(43) Date of publication of application: **20.05.2026**
(21) Application number: 25214592.5
(22) Date of filing: 10.11.2025
(51) Int. Cl.: H10D 30/01, H10D 30/47, H10P 14/20, H10D 30/67

(54) **SEMICONDUCTOR DEVICE AND METHOD OF MANUFACTURING THE SAME**

(30) Priority: 13.11.2024 KR 20240160972
(71) Applicant: Samsung Electronics Co., Ltd., Suwon-si, Gyeonggi-do 16677 (KR)
(72) Inventor: Ryu, Huije, 16678 Suwon-si, Gyeonggi-do (KR); Jung, Alum, 16678 Suwon-si, Gyeonggi-do (KR); Yoo, Minseok, 16678 Suwon-si, Gyeonggi-do (KR)
(74) Representative: Grünecker Patent- und Rechtsanwälte PartG mbB

(57) **Abstract**

A semiconductor device may include a first insulating layer and a channel formation layer on the first insulating layer, where the channel formation layer may include a two-dimensional semiconductor material. The channel formation layer may include an active semiconductor layer and an inactive semiconductor layer. The active semiconductor layer may be bonded to an upper surface of the first insulating layer with a first adhesion energy. The inactive semiconductor layer may be laterally bonded to the active semiconductor layer and may include an element included in the active semiconductor layer. In addition, the inactive semiconductor layer may be bonded to the upper surface of the first insulating layer with a second adhesion energy. The second adhesion energy may be greater than the first adhesion energy.

## Description

### BACKGROUND

### 1. Field

The disclosure relates to a semiconductor device and a method of manufacturing the semiconductor device.

### 2. Description of the Related Art

Transistors may be semiconductor devices that function as electrical switches and may be used in various integrated circuit (IC) devices such as memory, driver ICs, and logic devices. To increase the integration density of IC devices, the space occupied by transistors has been significantly reduced. This results in a decrease in the channel length of transistors and the thickness of layers of transistors.

As the miniaturization of field-effect transistors (FETs) progresses, research into replacing current FET channel materials with two-dimensional semiconductor materials has been conducted to reduce short-channel effects and enhance gate controllability.

To utilize two-dimensional semiconductor materials as transistor channels, a technique of patterning two-dimensional semiconductor materials to form channel regions may be necessary. Currently used silicon materials enable control of channel regions through doping levels. However, techniques of precisely controlling doping levels by region have not been developed for two-dimensional semiconductor materials. Thus, a method of directly removing (physically etching) regions other than a channel is used.

However, two-dimensional semiconductor materials have Van der Waals surfaces on which dangling bonds are not present, resulting in low adhesion energy between adjacent materials. In a structure in which a two-dimensional semiconductor channel is etched to have very small area of the channel in contact with a substrate, peeling of the two-dimensional semiconductor channel from the substrate is likely to occur due to low adhesion energy. In addition, because two-dimensional semiconductor materials have an extremely small thickness, physical damage is likely to occur within a channel region during a high-energy etching process. Therefore, there is a need to develop a method of precisely patterning a two-dimensional semiconductor channel region without causing damage.

### SUMMARY

Provided are a semiconductor device utilizing a two-dimensional semiconductor material and/or a method of manufacturing the semiconductor device.

Additional aspects will be set forth in part in the description which follows and, in part, will be apparent from the description, or may be learned by practice of the presented embodiments of the disclosure.

According to an example embodiment of the disclosure, a semiconductor device may include a first insulating layer; and a channel formation layer on the first insulating layer and including a two-dimensional semiconductor material. The channel formation layer may include an active semiconductor layer bonded to an upper surface of the first insulating layer with a first adhesion energy, and an inactive semiconductor layer laterally bonded to the active semiconductor layer. The inactive semiconductor layer may include an element included in the active semiconductor layer. The inactive semiconductor layer may be bonded to the upper surface of the first insulating layer with a second adhesion energy. The second adhesion energy may be greater than the first adhesion energy.

In some embodiments, the active semiconductor layer may be Van der Waals bonded to the upper surface of the first insulating layer.

In some embodiments, the inactive semiconductor layer may have a structure in which a material forming the active semiconductor layer is oxidized, nitrided, or amorphized.

In some embodiments, the active semiconductor layer may include a transition metal dichalcogenide (TMD) material.

In some embodiments, the inactive semiconductor layer may include a transition metal and a chalcogen element that are included in the TMD material, and the inactive semiconductor layer may further include oxygen or nitrogen.

In some embodiments, the semiconductor device may further include a second insulating layer on the active semiconductor layer; a source electrode electrically connected to a first end of the active semiconductor layer; a drain electrode electrically connected to a second end of the active semiconductor layer; and an upper gate electrode on the second insulating layer.

In some embodiments, the semiconductor device may further include a lower gate electrode under the first insulating layer.

In some embodiments, the upper gate electrode and the lower gate electrode each may include an active gate region and an inactive gate region. The inactive gate region of the upper gate electrode may face the inactive semiconductor layer. The inactive gate region of the lower gate electrode may face the inactive semiconductor layer.

In some embodiments, in the upper gate electrode and the lower gate electrode, the inactive gate region may have a structure in which a conductive material included in the active gate region is insulated.

According to an example embodiment of the disclosure, an electronic apparatus may include a semiconductor device; and a controller configured to control the semiconductor device. The semiconductor device may include a first insulating layer comprising an insulating material, and a channel formation layer on the first insulating layer. The channel formation layer may include a two-dimensional semiconductor material. The channel formation layer may include an active semiconductor layer bonded to an upper surface of the first insulating layer with a first adhesion energy, and
an inactive semiconductor layer laterally bonded to the active semiconductor layer. The inactive semiconductor layer may include an element in the active semiconductor layer. The inactive semiconductor layer may be bonded to an upper surface of the first insulating layer with a second adhesion energy. The second adhesion energy may be greater than the first adhesion energy.

According to an example embodiment of the disclosure, a method of manufacturing a semiconductor device may include forming a two-dimensional semiconductor material layer on a first insulating layer, the two-dimensional semiconductor material layer comprising a two-dimensional semiconductor material, and the first insulating layer comprising an insulating material; and forming a channel formation layer comprising an inactive semiconductor layer and an active semiconductor layer by irradiating a portion of the two-dimensional semiconductor material layer with a plasma or an ion beam.

In some embodiments, the two-dimensional semiconductor material layer may be bonded to the first insulating layer with a first adhesion energy, the inactive semiconductor layer may be bonded to the first insulating layer with a second adhesion energy, and the second adhesion energy may be greater than the first adhesion energy.

In some embodiments, the method may further include: prior to the forming the channel formation layer, forming a second insulating layer on the two-dimensional semiconductor material layer.

In some embodiments, the second insulating layer may have a thickness of 5 nm or less.

In some embodiments, the method may further include forming a gate electrode on a region of the second insulating layer that overlaps the active semiconductor layer.

In some embodiments, the forming the channel formation layer may include arranging a mask layer on the two-dimensional semiconductor material layer, and the mask layer may expose a portion of the two-dimensional semiconductor material layer.

In some embodiments, the mask layer may include a photoresist material, an electron-beam (e-beam) resist material, or a metal material.

In some embodiments, the method may further include, prior to the forming the channel formation layer, forming a first conductive layer and a second conductive layer on a lower side of the two-dimensional semiconductor material layer and an upper side of the two-dimensional semiconductor material layer, respectively.

In some embodiments, in the forming the channel formation layer, a region of the first conductive layer may be electrically inactivated and a region of the second conductive layer may be electrically inactivated to provide an electrically inactivated region of the first conductive layer and an electrically inactivated region of the second conductive layer.

In some embodiments, the electrically inactivated region of the first conductive layer and the electrically inactivated region of the second conductive layer may face each other with the inactive semiconductor layer therebetween.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a perspective view illustrating a schematic structure of a semiconductor device according to an embodiment;
FIG. 2 is a perspective view illustrating a structure of a channel formation layer provided in the semiconductor device shown in FIG. 1;
FIG. 3A is a cross-sectional view taken along line A-A of FIG. 1;
FIG. 3B is a cross-sectional view taken along line B-B of FIG. 1;
FIG. 4 is an enlarged view illustrating a portion of FIG. 3B;
FIG. 5A is a cross-sectional view illustrating a schematic structure of a semiconductor device according to a comparative example, and FIG. 5B is an enlarged view illustrating a portion of FIG. 5A;
FIGS. 6A and 6B are cross-sectional views illustrating a schematic structure of a semiconductor device according to another embodiment, showing different cross-sections of the semiconductor device;
FIGS. 7A to 7F are views illustrating a method of manufacturing a semiconductor device according to an embodiment;
FIG. 8 is a graph illustrating a photoluminescence (PL) spectrum of a two-dimensional semiconductor material before and after an inactivation process, in a semiconductor device manufacturing method according to an embodiment;
FIG. 9 is a graph comparing gate voltage transfer characteristics of a semiconductor device of a comparative example with gate voltage transfer characteristics of a semiconductor device of an embodiment;
FIGS. 10A to 10G are views illustrating a method of manufacturing a semiconductor device according to another embodiment;
FIGS. 11A to 11F are views illustrating a method of manufacturing a semiconductor device according to another embodiment;
FIG. 12 is a block diagram schematically illustrating a display driver integrated circuit (display driver IC or DDI) and a display apparatus including the DDI, according to an embodiment;
FIG. 13 is a circuit diagram illustrating a complementary metal oxide semiconductor (CMOS) inverter according to an embodiment;
FIG. 14 is a circuit diagram illustrating a CMOS static random-access memory (SRAM) device according to an embodiment;
FIG. 15 is a circuit diagram illustrating a CMOS NAND circuit according to an embodiment;
FIG. 16 is a block diagram illustrating an electronic apparatus according to an embodiment; and
FIG. 17 is a block diagram illustrating an electronic apparatus according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described with reference to the accompanying drawings. The embodiments described herein are for illustrative purposes only, and various modifications may be made therein. In the drawings, like reference numerals refer to like elements, and the sizes of elements may be exaggerated for clarity of illustration.

In the following description, when an element is referred to as being "above" or "on" another element, it may be directly on the other element while making contact with the other element or may be above the other element without making contact with the other element.

Although the terms "first" and "second" are used to describe various elements, these terms are only used to distinguish one element from another element. These terms do not limit elements to having different materials or structures.

The terms of a singular form may include plural forms unless otherwise mentioned. It will be further understood that the terms "comprises" and/or "comprising" used herein specify the presence of stated features or elements, but do not preclude the presence or addition of one or more other features or elements.

In the present disclosure, terms such as "unit" or "module" may be used to denote a unit that has at least one function or operation and is implemented with hardware, software, or a combination of hardware and software.

An element referred to with the definite article or a demonstrative determiner may be construed as the element or the elements even though it has a singular form.

Operations of a method may be performed in appropriate order unless explicitly described in terms of order or described to the contrary. In addition, examples or exemplary terms (for example, "such as" and "etc.") are used for the purpose of description and are not intended to limit the scope of the disclosure unless defined by the claims.

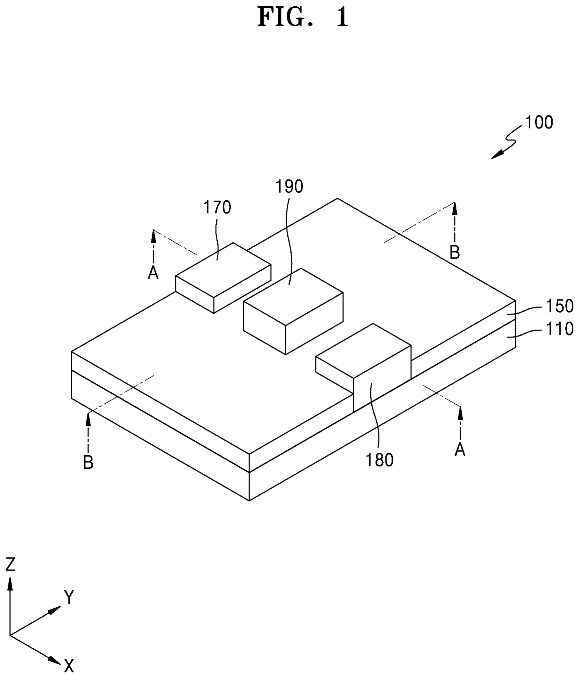

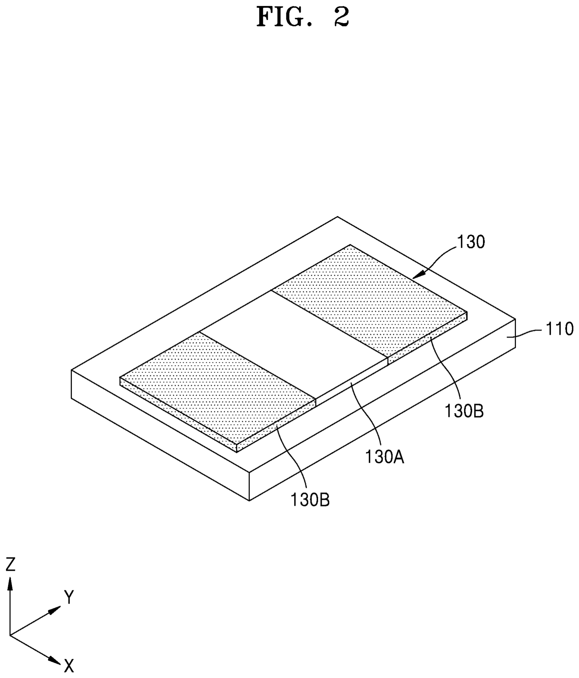

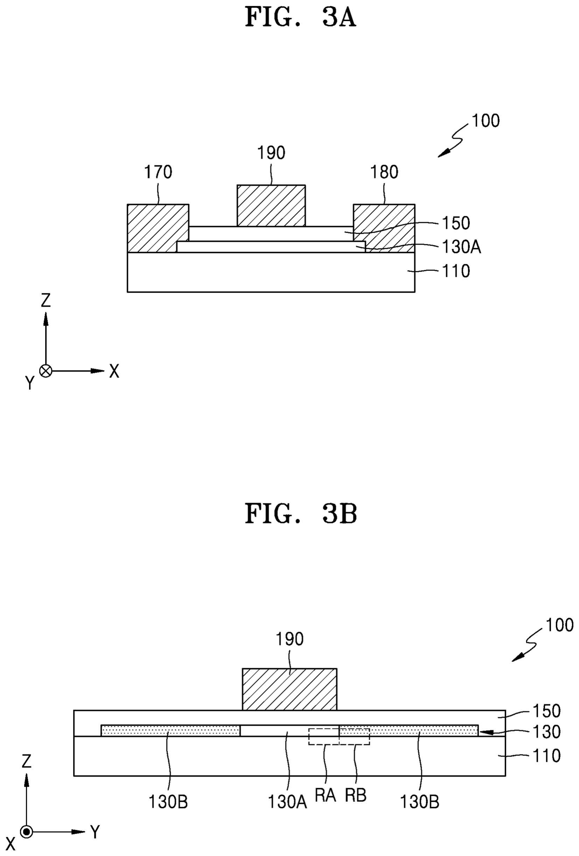

FIG. 1 is a perspective view illustrating a schematic structure of a semiconductor device 100 according to an embodiment. FIG. 2 is a perspective view illustrating a structure of a channel formation layer 130 provided in the semiconductor device 100 shown in FIG. 1. FIGS. 3A and 3B are cross-sectional views respectively taken along lines A-A and B-B of FIG. 1.

The semiconductor device 100 includes a substrate 110 and the channel formation layer 130 formed on the substrate 110.

The substrate 110 may be an insulating substrate or a semiconductor substrate with an insulating layer formed on a surface thereof. The semiconductor substrate may include a material such as Si, Ge, SiGe, or a Group III-V semiconductor material. The substrate 110 may be, for example, a silicon substrate with a silicon oxide formed on a surface thereof, but is not limited thereto. The substrate 110 may be selected from various substrates as long as a surface making contact with the channel formation layer 130 includes an insulating material.

The channel formation layer 130 includes a two-dimensional semiconductor material. The two-dimensional semiconductor material may exhibit outstanding electrical characteristics, and even when the two-dimensional semiconductor material has a small nanoscale thickness, the two-dimensional semiconductor material may maintain high mobility without significant changes in characteristics. The two-dimensional semiconductor material may have a monolayer structure, or a multilayer structure such as a bilayer structure or a trilayer structure. Each layer of the two-dimensional semiconductor material may have an atomic level thickness. The thickness of the channel formation layer 130 may be about 10 nm or less, or about 5 nm or less, or about 3 nm or less. The thickness of the channel formation layer 130 is not limited thereto and may be further reduced.

The two-dimensional semiconductor material may include an n-type two-dimensional semiconductor such as MoS₂, MoSe₂, MoTe₂, or WS₂, or a p-type two-dimensional semiconductor such as WSe₂, MoTe₂, or PtSe₂. The two-dimensional semiconductor material may include a transition metal dichalcogenide (TMD). The TMD may include a metal element selected from Mo, W, Nb, V, Ta, Ti, Zr, Hf, Tc, Re, Cu, Ga, In, Sn, Ge, and Pb, and a chalcogen element selected from S, Se, and Te. In addition, graphene, black phosphorus, amorphous boron nitride, or phosphorene may be used as the two-dimensional semiconductor material.

A region of the channel formation layer 130 may be divided into an active semiconductor layer 130A and inactive semiconductor layer 130B. The active semiconductor layer 130A and the inactive semiconductor layer 130B are laterally bonded to each other. The inactive semiconductor layer 130B may be formed based on the two-dimensional semiconductor material forming the active semiconductor layer 130A, but differ from the active semiconductor layer 130A in that electrical characteristics of the inactive semiconductor layer 130B are inactivated or insulated. The inactive semiconductor layer 130B may include elements included in the active semiconductor layer 130A. The inactive semiconductor layer 130B may have a structure in which a material forming the active semiconductor layer 130A is oxidized, nitrided, or amorphized. The active semiconductor layer 130A may include a two-dimensional semiconductor material selected from the various two-dimensional semiconductor materials described above, and the inactive semiconductor layer 130B may include elements contained in such two-dimensional semiconductor materials and may further include additional elements. For example, the active semiconductor layer 130A may include a TMD material. In this case, the inactive semiconductor layer 130B may include a transition metal and a chalcogen element that are contained in the TMD material of the active semiconductor layer 130A, and may further include oxygen or nitrogen.

Adhesion energy between the substrate 110 and the inactive semiconductor layer 130B is greater than adhesion energy between the substrate 110 and the active semiconductor layer 130A. For example, an average force needed to separate the inactive semiconductor layer 130B from the substrate 110 may be greater than an average force needed to separate the active semiconductor layer 130A from the substrate 110. An interface between the substrate 110 and the active semiconductor layer 130A including the two-dimensional semiconductor material is defined as a Van der Waals interface. The inactive semiconductor layer 130B has a structure in which the material of the active semiconductor layer 130A, that is, the two-dimensional semiconductor material, is oxidized, nitrided, or amorphized. Therefore, an interface between the substrate 110 and the inactive semiconductor layer 130B is not defined as a Van der Waals interface and thus has greater adhesion energy than the Van der Waals interface. In this manner, the active semiconductor layer 130A is laterally bonded to the inactive semiconductor layer 130B that is bonded to the substrate 110 with high adhesion energy, and thus, bonding between the active semiconductor layer 130A and the substrate 110 may be stabilized by the inactive semiconductor layer 130B.

Referring to FIG. 2, both lateral regions of the channel formation layer 130 are inactivated. That is, the channel formation layer 130 includes two inactive semiconductor layers 130B at both sides thereof, and one active semiconductor layer 130A between the two inactive semiconductor layers 130B. Due to the inactive semiconductor layers 130B, the width of a channel region is determined by a width of the active semiconductor layer 130A, for example, a Y-direction width of the active semiconductor layer 130A. As described above, the semiconductor device 100 of the embodiment has a structure in which the active semiconductor layer 130A of the channel formation layer 130, excluding the inactive semiconductor layers 130B of the channel formation layer 130, is defined as a channel. Therefore, stable contact may be ensured between the substrate 110 and the channel even though the channel has a small size.

A gate insulating layer 150 may be disposed on the channel formation layer 130. The gate insulating layer 150 may include an insulating material selected from various types of insulating materials. The insulating material may include a high-k material, that is, a high-k dielectric material, such as aluminum oxide, hafnium oxide, zirconium hafnium oxide, or lanthanum oxide. However, embodiments are not limited thereto. Alternatively, the insulating material may include a ferroelectric material. The ferroelectric material exhibits spontaneous electric dipoles, that is, spontaneous polarization due to a non-centrosymmetric charge distribution within unit cells of a crystallized structure of the ferroelectric material. Thus, the ferroelectric material has remnant polarization due to dipoles even in the absence of an external electric field. In addition, the direction of polarization of the ferroelectric material may be switched in units of domains by an external electric field. The ferroelectric material may include an oxide of at least one selected from Hf, Si, Al, Zr, Y, La, Gd, and Sr. However, the listed elements are merely examples. In addition, the ferroelectric material may further include a dopant in some cases.

When the insulating material of the gate insulating layer 150 includes the ferroelectric material, the semiconductor device 100 may be a field-effect transistor (FET) that may be used as a logic device or a memory device. The ferroelectric material may reduce subthreshold swing (SS) by the negative capacitance effect of the ferroelectric material, and thus, the semiconductor device 100 may operate as an FET having a reduced size and improved performance.

The gate insulating material may have a bilayer structure including a high-k material and a ferroelectric material.

A gate electrode 190 may be disposed on the gate insulating layer 150 at a position opposite the active semiconductor layer 130A of the channel formation layer 130. A source electrode 170 and a drain electrode 180 may be electrically connected to both ends of the active semiconductor layer 130A, respectively.

The gate electrode 190 may include a metal material or a conductive oxide. For example, the metal material may include at least one selected from Au, Ti, TiN, TaN, W, Mo, WN, Pt, and Ni. For example, the conductive oxide may include indium tin oxide (ITO), indium zinc oxide (IZO), or the like.

The source electrode 170 and the drain electrode 180 may include a metal material having high electrical conductivity. For example, the source electrode 170 and the drain electrode 180 may include a metal such as magnesium (Mg), aluminum (Al), scandium (Sc), titanium (Ti), vanadium (V), chromium (Cr), manganese (Mn), nickel (Ni), copper (Cu), zinc (Zn), gallium (Ga), zirconium (Zr), niobium (Nb), molybdenum (Mo), palladium (Pd), silver (Ag), cadmium (Cd), indium (In), tin (Sn), lanthanum (La), hafnium (Hf), tantalum (Ta), tungsten (W), iridium (Ir), platinum (Pt), gold (Au), or bismuth (Bi), or an alloy thereof.

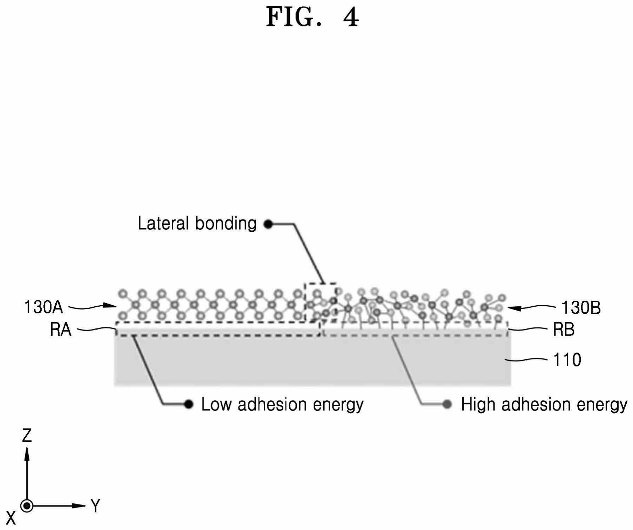

FIG. 4 is an enlarged view illustrating a portion of FIG. 3B.

A region RA refers to a bonding region between the active semiconductor layer 130A and the substrate 110, and a region RB refers to a bonding region between an inactive semiconductor layer 130B and the substrate 110.

The inactive semiconductor layers 130B are in an electrically insulated state in which the two-dimensional semiconductor material is amorphized, oxidized, or nitrided.

The two-dimensional semiconductor material includes a Van der Waals surface that does not have dangling bonds. Therefore, the two-dimensional semiconductor material has low adhesion energy between adjacent materials. For example, a surface of the substrate 110 is Van der Waals bonded to the active semiconductor layer 130A, and thus, the region RA has low adhesion energy.

In contrast, unlike the active semiconductor layer 130A, the inactive semiconductor layers 130B, which are in an insulated state, form dangling bonds at bonding interfaces with the substrate 110, and thus, the region RB has high adhesion energy. In addition, because the active semiconductor layer 130A and the inactive semiconductor layers 130B are laterally bonded to each other, the bonding between the active semiconductor layer 130A and the substrate 110 is stabilized by the inactive semiconductor layers 130B.

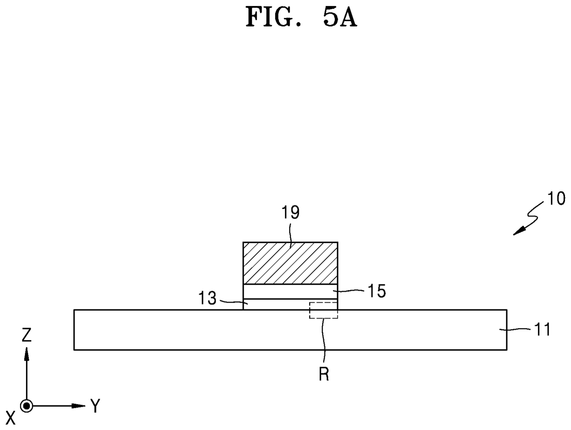

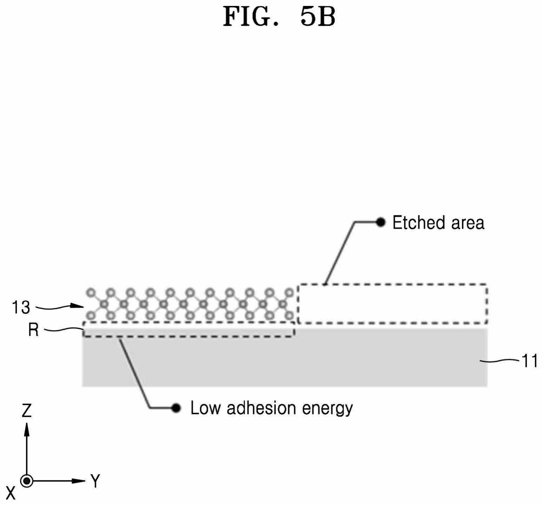

FIG. 5A is a cross-sectional view illustrating a schematic structure of a semiconductor device 10 according to a comparative example, and FIG. 5B is an enlarged view illustrating a portion of FIG. 5A.

The semiconductor device 10 of the comparative example includes a substrate 11, a two-dimensional semiconductor layer 13, a gate insulating layer 15, and a gate electrode 19. The two-dimensional semiconductor layer 13 is patterned to a width shown in FIG. 5A by widely forming the two-dimensional semiconductor layer 13 on a surface of the substrate 11 and then partially removing the two-dimensional semiconductor layer 13 through etching.

A region R refers to a bonding region between the two-dimensional semiconductor layer 13 and the substrate 11, which is a Van der Waals bonding region having low adhesion energy. The two-dimensional semiconductor layer 13 has an unstable bonding state with the substrate 11 and may thus be damaged. For example, the two-dimensional semiconductor layer 13 may be partially removed from the surface of the substrate 11 while being patterned to the width shown in FIG. 5A.

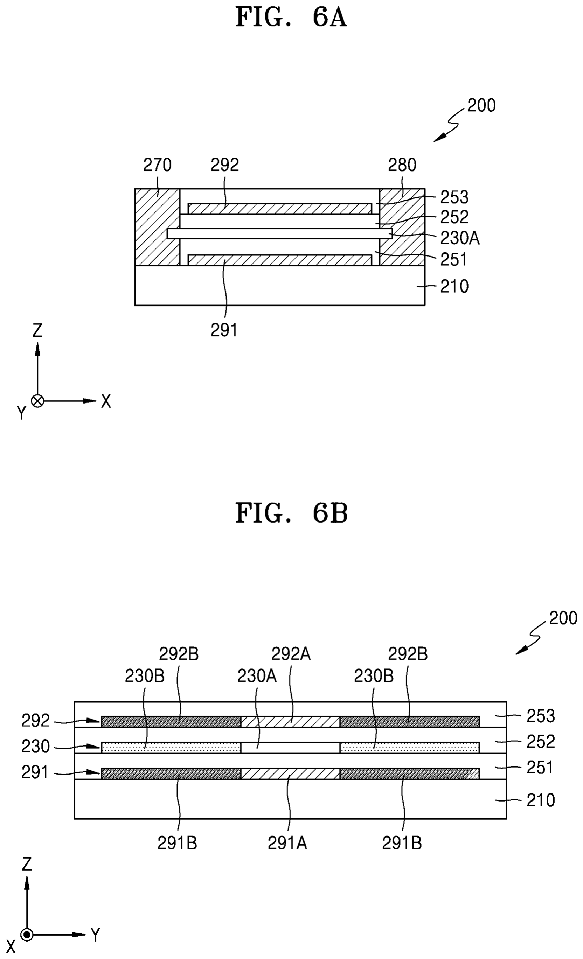

FIGS. 6A and 6B are cross-sectional views illustrating a schematic structure of a semiconductor device 200 according to another embodiment, showing different cross-sections of the semiconductor device 200.

The semiconductor device 200 includes a substrate 210, a channel formation layer 230 formed above the substrate 210, a lower gate electrode 291 formed under the channel formation layer 230, and an upper gate electrode 292 formed above the channel formation layer 230. A first gate insulating layer 251 is disposed between the lower gate electrode 291 and the channel formation layer 230, a second gate insulating layer 252 is disposed between the channel formation layer 230 and the upper gate electrode 292.

Like the channel formation layer 130 described with reference to FIG. 2, the channel formation layer 230 may include an active semiconductor layer 230A and inactive semiconductor layers 230B. A source electrode 270 and a drain electrode 280 may be electrically connect to both ends of the active semiconductor layer 230A, respectively.

The upper gate electrode 292 includes an active gate region 292A and inactive gate regions 292B, and the active gate region 292A faces the active semiconductor layer 230A.

The lower gate electrode 291 also includes an active gate region 291A and inactive gate regions 291B, and the active gate region 291A faces the active semiconductor layer 230A.

The active gate regions 291A and 292A may each independently include a conductive material selected from the various conductive materials that are described above as materials of the gate electrode 190.

The inactive gate regions 291B may have a structure in which the conductive material of the active gate region 291A is insulated. The inactive gate regions 292B may have a structure in which the conductive material of the active gate region 292A is insulated.

The semiconductor device 200 of the current embodiment may operate as a transistor that uses, as a channel, the active semiconductor layer 230A including a two-dimensional semiconductor material. In this structure, the active gate region 292A and the active gate region 291B are positioned above and below the active semiconductor layer 230A, substantially forming a gate-all-around (GAA) structure.

Forming the active gate region 292A and the inactive gate regions 292B in the upper gate electrode 292, forming the active semiconductor layer 230A and the inactive semiconductor layers 230B in the channel formation layer 230, and forming the active gate region 291A and the inactive gate regions 291B in the lower gate electrode 291 may be performed in the same process.

FIGS. 6A and 6B illustrate an example in which the semiconductor device 200 includes one channel formation layer 230. In other embodiments, however, a semiconductor device may include a plurality of channel formation layers, and gate electrodes may be provided above and below each of the channel formation layers.

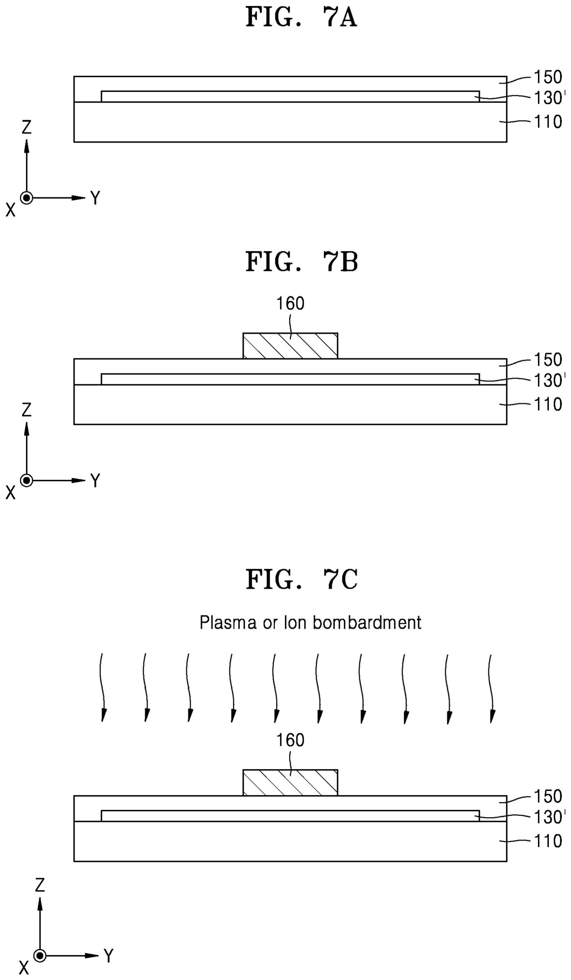

FIGS. 7A to 7F are views illustrating a method of manufacturing a semiconductor device according to an embodiment.

Referring to FIG. 7A, a two-dimensional semiconductor material layer 130' may be formed on a substrate 110, and a gate insulating layer 150 may be formed on the two-dimensional semiconductor material layer 130'.

The substrate 110 may be an insulating substrate or a semiconductor substrate with an insulating layer formed a surface thereof.

The two-dimensional semiconductor material layer 130' may be directly formed on the substrate 110 or may be formed on another substrate and then transferred onto the substrate 110.

A two-dimensional semiconductor material included in the two-dimensional semiconductor material layer 130' may be formed, for example, by a method such as metal organic chemical vapor deposition (MOCVD) or atomic layer deposition (ALD). The two-dimensional semiconductor material layer 130' may include a monolayer or multilayer structure including the two-dimensional semiconductor material.

The gate insulating layer 150 may include an insulating material and may be formed by ALD. However, embodiments are not limited thereto. The gate insulating layer 150 may have a thickness of about 10 nm or less, or about 5 nm or less. However, the gate insulating layer 150 is not limited thereto, and the thickness of the gate insulating layer 150 may be determined considering a subsequent channel inactivation process.

Referring to FIG. 7B, a mask layer 160 is disposed on the gate insulating layer 150. The mask layer 160 has a pattern corresponding to a region that is to be formed as an active semiconductor layer. In other words, the mask layer 160 has a pattern through which regions to be formed as inactive semiconductor layers are open. The mask layer 160 may include a photoresist material, an electron beam (e-beam) resist material, or a metal material.

Referring to FIG. 7C, a process of inactivating portions of the two-dimensional semiconductor material layer 130' is performed. The inactivation process may be a plasma or ion-beam process. The plasma process may be, for example, an O₂ plasma process. However, the plasma process is not limited thereto and may be performed based on other gases such as nitrogen.

After the inactivation process, the mask layer 160 is removed.

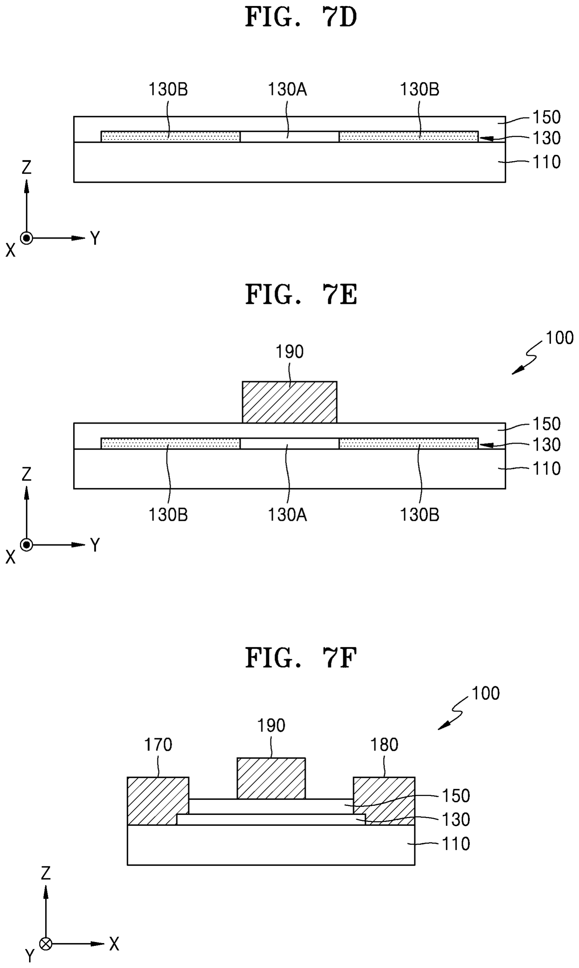

Referring to FIG. 7D, a channel formation layer 130 is provided, which includes an active semiconductor layer 130A that maintains electrical properties of the two-dimensional semiconductor material, and inactive semiconductor layers 130B that are electrically inactive.

As described with reference to FIG. 7C, the inactivation process may be performed in a state in which the gate insulating layer 150 is formed on the two-dimensional semiconductor material layer 130', and the thickness of the gate insulating layer 150 may be predetermined considering the inactivation process. In some cases, a process of increasing the thickness of the gate insulating layer 150, that is, additionally depositing an insulating material, may be performed after the inactivation process.

Referring to FIG. 7E, a gate electrode 190 is formed on the gate insulating layer 150 in a region facing the active semiconductor layer 130A, thereby providing a semiconductor device 100. The gate electrode 190 may be formed, for example, by ALD, but is not limited thereto.

Referring to FIG. 7F showing a cross-section perpendicular to a cross-section shown in FIG. 7E, a source electrode 170 and a drain electrode 180 are electrically connect to both ends of the active semiconductor layer 130A.

The order of forming the source electrode 170, the drain electrode 180, and the gate electrode 190 is not specifically limited. For example, the source electrode 170, the drain electrode 180, and the gate electrode 190 may be formed in the same process. For example, after etching portions of the gate insulating layer 150 to expose both end portions of the active semiconductor layer 130A, a conductive material layer entirely covering the active semiconductor layer 130A and the gate insulating layer 150 may be formed, and then, the conductive material layer may be patterned corresponding to the gate electrode 190, the source electrode 170, and the drain electrode 180.

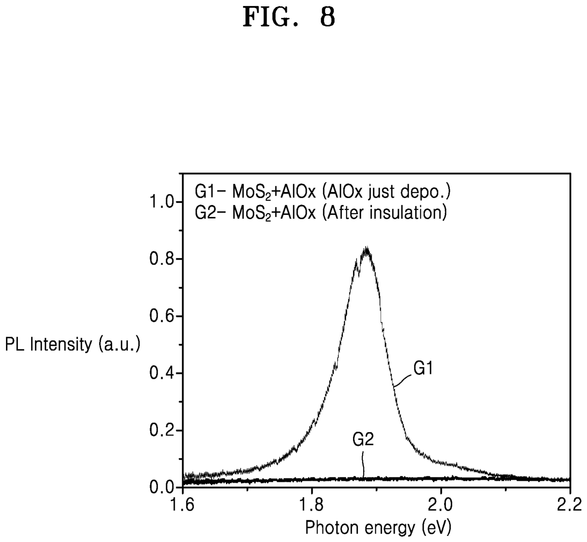

FIG. 8 is a graph illustrating a photoluminescence (PL) spectrum of the two-dimensional semiconductor material before and after the inactivation process of the semiconductor device manufacturing method of the embodiment.

The graph was obtained for the case in which the two-dimensional semiconductor material layer 130' includes MoS₂ and the gate insulating layer 150 includes AlOₓ. In the graph, a curve G1 was obtained before the inactivation process, and a curve G2 was obtained after an O₂ plasma process was performed as the inactivation process. Comparing the curves G1 and G2, no PL signal is observed in the curve G2. The reason for this is that the crystal structure of MoS₂ was altered by the inactivation process, causing a change in the band structure of MoS₂.

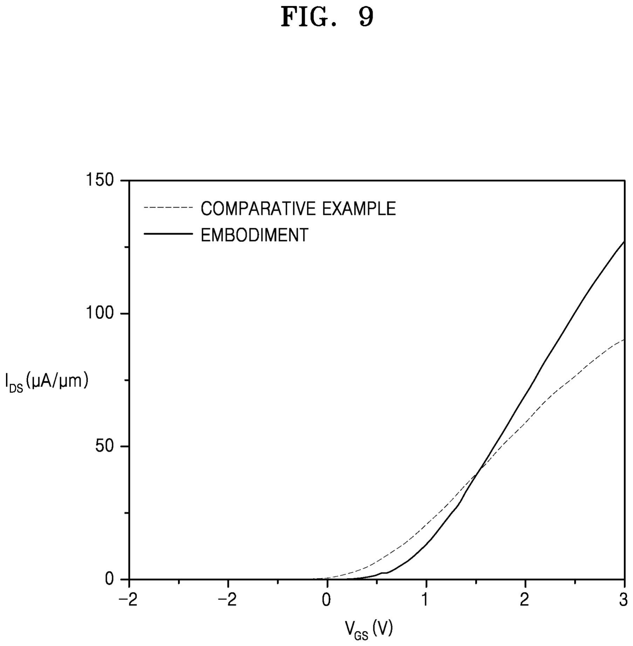

FIG. 9 is a graph comparing gate voltage transfer characteristics of a semiconductor device of a comparative example with gate voltage transfer characteristics of a semiconductor device of an embodiment.

The semiconductor device of the comparative example has a channel formed by patterning a two-dimensional semiconductor material via direct etching of the two-dimensional semiconductor material. It is confirmed that the semiconductor device of the embodiment has a relatively high current level. The reason for this may be that insulation-based patterning of the embodiment reduces channel damage compared to etch-based patterning of the comparative example.

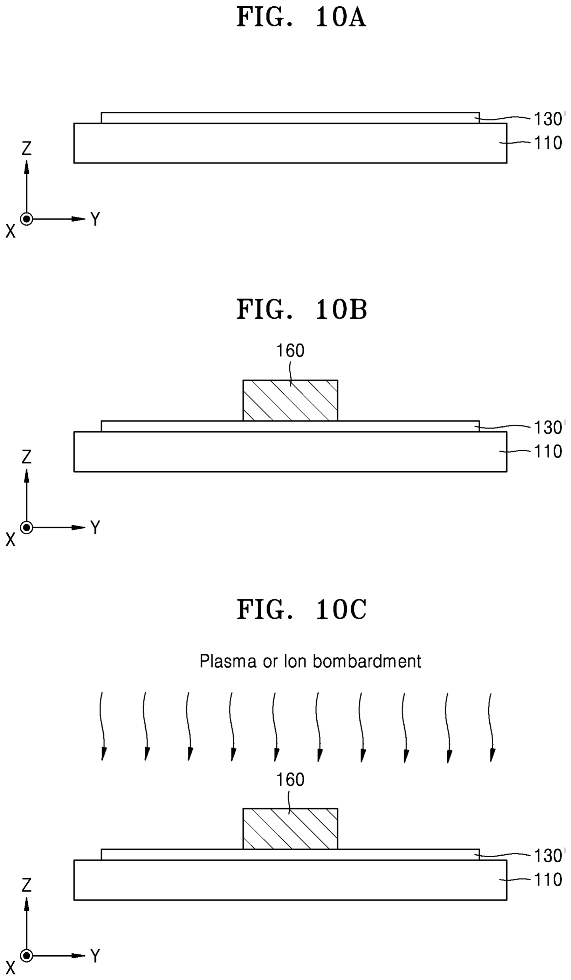

FIGS. 10A to 10G are views illustrating a method of manufacturing a semiconductor device according to another embodiment.

Referring to FIG. 10A, a two-dimensional semiconductor material layer 130' is formed on a substrate 110.

Referring to FIG. 10B, a mask layer 160 is provided on the two-dimensional semiconductor material layer 130'.

Referring to FIG. 10C, an inactivation process is performed on portions of the two-dimensional semiconductor material layer 130' by using plasma or an ion beam. After the inactivation process, the mask layer 160 is removed.

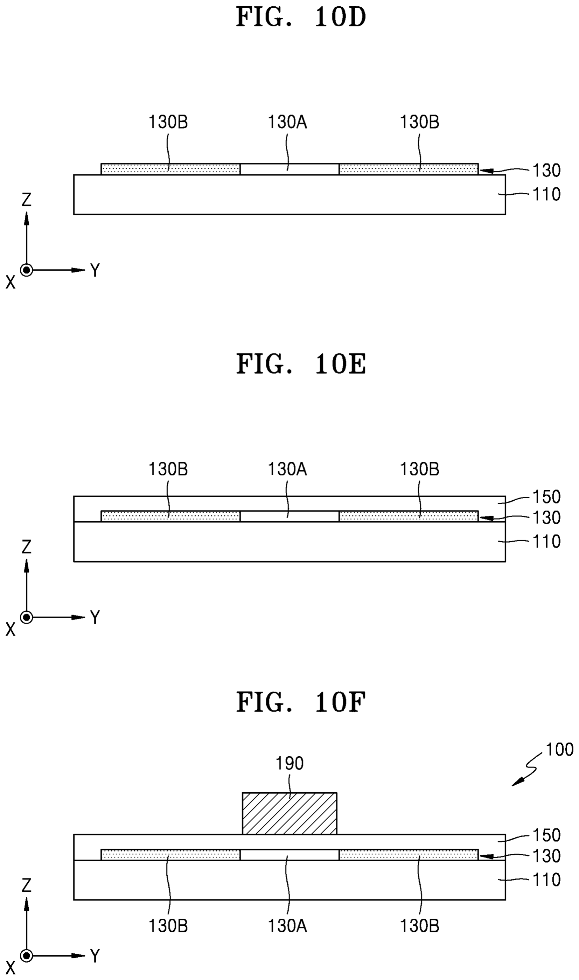

Referring to FIG. 10D, a channel formation layer 130 including an active semiconductor layer 130A and inactive semiconductor layers 130B is provided as a result of the inactivation process.

Referring to FIG. 10E, a gate insulating layer 150 is formed on the channel formation layer 130.

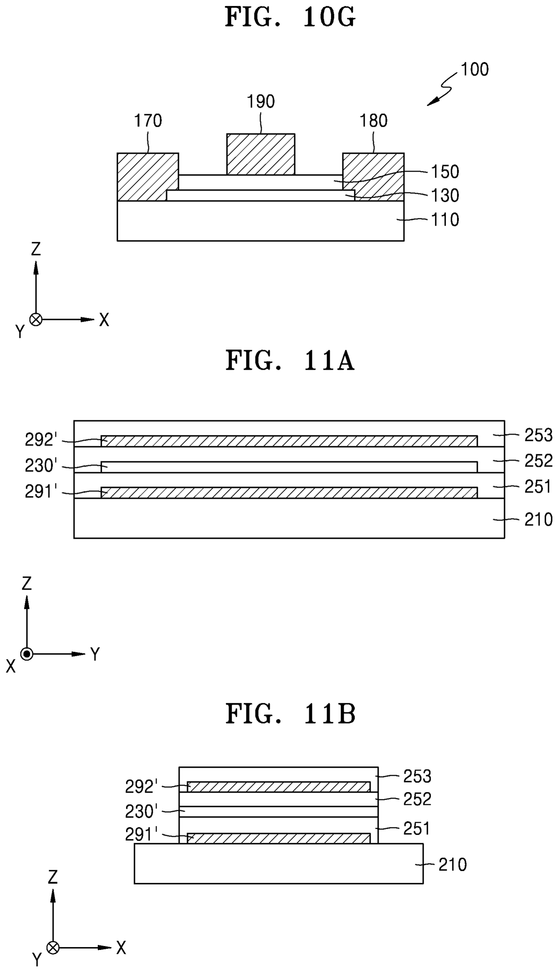

Next, as shown in FIGS. 10F and 10G, a gate electrode 190, a source electrode 170, and a drain electrode 180 are formed, thereby providing a semiconductor device 100.

The manufacturing method of the current embodiment differs from the manufacturing method described with reference to FIGS. 7A to 7F in that the inactivation process is performed before forming the gate insulating layer 150. Therefore, descriptions of the same processes are omitted.

FIGS. 11A to 11F are views illustrating a method of manufacturing a semiconductor device according to another embodiment.

FIGS. 11A and 11B are views illustrating cross-sections perpendicular to each other. Referring to FIGS. 11A and 11B, a first conductive layer 291', a first gate insulating layer 251, a two-dimensional semiconductor material layer 230', a second gate insulating layer 252, a second conductive layer 292', and an insulating layer 253 are sequentially formed on a substrate 210. The insulating layer 253 may be omitted.

The substrate 210 may be an insulating substrate or a semiconductor substrate with an insulating layer formed on a surface thereof.

The first conductive layer 291' and the second conductive layer 292' may each independently include a conductive material selected from the various conductive materials described above.

The first gate insulating layer 251, the second gate insulating layer 252, and the insulating layer 253 may each independently include an insulating material selected from the various insulating materials described above.

The two-dimensional semiconductor material layer 230' may include a two-dimensional semiconductor material selected from the various two-dimensional semiconductor materials described above. The two-dimensional semiconductor material layer 230' may be directly formed on the first gate insulating layer 251 or may be formed on another substrate and then transferred onto the first gate insulating layer 251.

The two-dimensional semiconductor material included in the two-dimensional semiconductor material layer 230' may be formed, for example, by a method such as MOCVD or ALD.

The first conductive layer 291', the first gate insulating layer 251, the second gate insulating layer 252, the second conductive layer 292', and the insulating layer 253 may be formed by various deposition methods such as ALD.

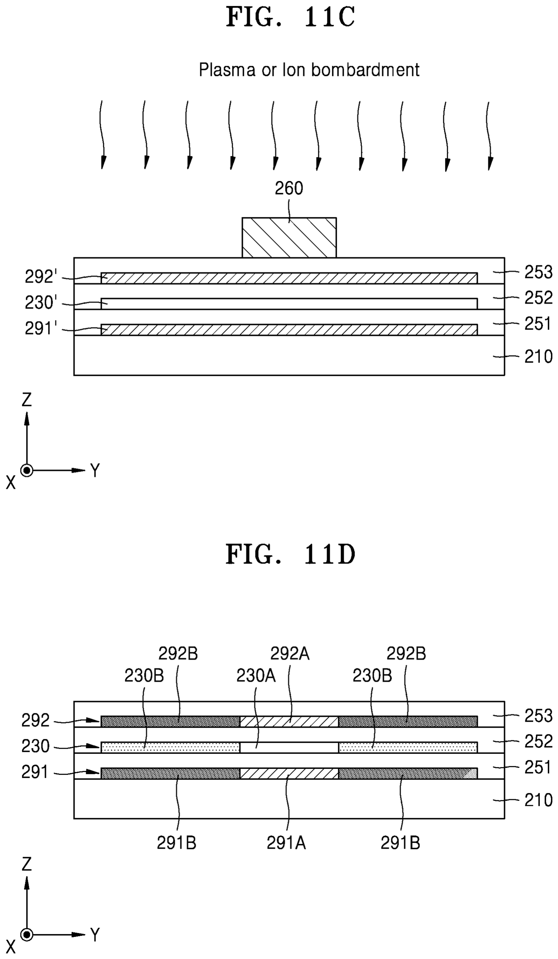

Referring to FIG. 11C, a mask layer 260 is disposed on the insulating layer 253, and an inactivation process is performed. When the insulating layer 253 is omitted, the inactive process may be performed in a state in which the mask layer 260 is disposed on the second conductive layer 292'. After the inactivation process, the mask layer 160 is removed.

Referring to FIG. 11D, a lower gate electrode 291 including an active gate region 291A and inactive gate regions 291B, a channel formation layer 230 including an active semiconductor layer 230A and inactive semiconductor layers 230B, and an upper gate electrode 292 including an active gate region 292A and inactive gate regions 292B are formed as a result of the inactivation process.

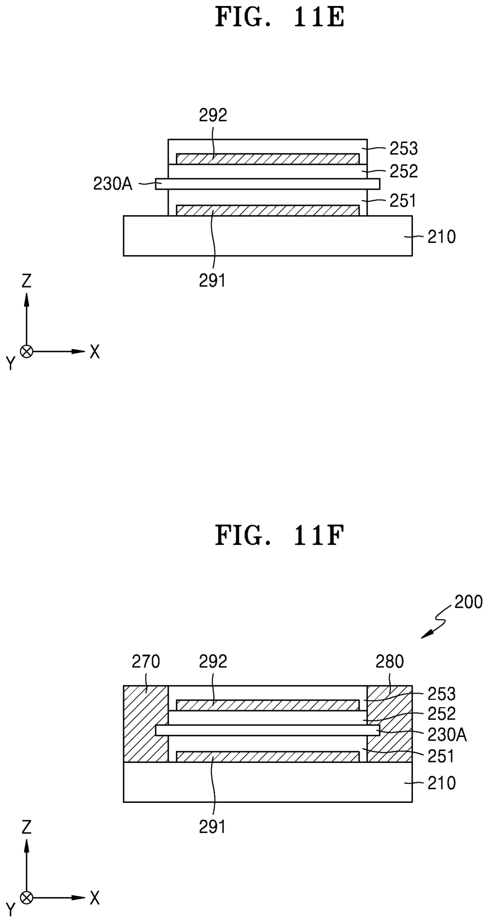

FIG. 11E is a view illustrating a cross-section perpendicular to a cross-section shown in FIG. 11D. Portions of the first gate insulating layer 251 and the second gate insulating layer 252 are etched to expose portions of the active semiconductor layer 230A.

Referring to FIG. 11F, a source electrode 270 and a drain electrode 280 electrically connected to both ends of the active semiconductor layer 230A are formed.

The manufacturing method described with reference to FIGS. 11A to 11F is an example in which regions of the first conductive layer 291', the two-dimensional semiconductor material layer 230', and the second conductive layer 292' are inactivated in the same inactivation process. Therefore, unrelated other processes may be changed. For example, after the source electrode 270 and the drain electrode 280 are formed on the substrate 210, the first conductive layer 291', the two-dimensional semiconductor material layer 230', and the second conductive layer 292' may be formed, and then, the inactivation process may be performed.

The semiconductor devices 100 and 200 of the embodiments described above, and the semiconductor devices 100 and 200 provided by the manufacturing methods of the embodiments described above may exhibit high electrical performance while having a small size, and may thus be applicable to integrated circuit devices. The semiconductor devices 100 and 200 of the embodiments may be used as logic transistors and may be applied to various electronic apparatuses together with a controller for controlling the logic transistors.

For example, the semiconductor devices 100 and 200 described above may be used in display driver integrated circuits (display driver ICs or DDIs), complementary metal oxide semiconductor (CMOS) inverters, CMOS static random access memory (SRAM) devices, CMOS NAND circuits, and/or various other electronic apparatuses.

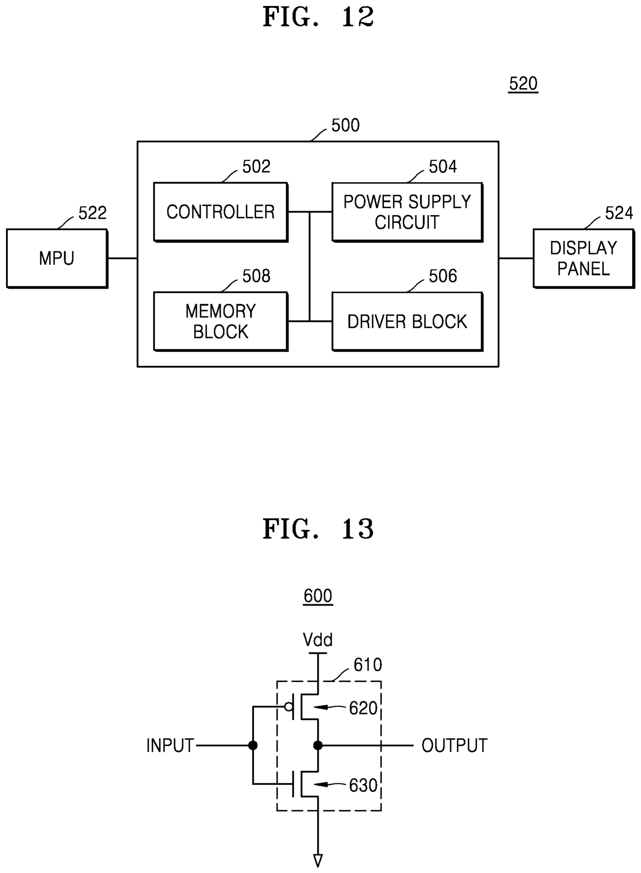

FIG. 12 is a block diagram schematically illustrating a display apparatus 520 including a DDI 500 according to an embodiment.

Referring to FIG. 12, the DDI 500 may include a controller 502, a power supply circuit 504, a driver block 506, and a memory block 508. The controller 502 receives and decodes instructions from a main processing unit (MPU) 522 and controls each block of the DDI 500 to perform operations according to the instructions. The power supply circuit 504 generates driving voltages in response to control by the controller 502. The driver block 506 drives a display panel 524 using the driving voltages generated by the power supply circuit 504 in response to control by the controller 502. The display panel 524 may include a liquid crystal display (LCD) panel, an organic light-emitting device (OLED) display panel, or a plasma display panel. The memory block 508 may temporarily store instructions input to the controller 502, control signals output from the controller 502, or other necessary data. The memory block 508 may include memory such as random-access memory (RAM) or read-only memory (ROM). The power supply circuit 504 and the driver block 506 may include one of the semiconductor devices 100 and 200 of the embodiments described with reference to FIGS. 1 to 4 and 6A to 11F, or a combination of modifications of the semiconductor devices 100 and 200.

FIG. 13 is a circuit diagram illustrating a CMOS inverter 600 according to an embodiment.

Referring to FIG. 13, the CMOS inverter 600 includes a CMOS transistor 610. The CMOS transistor 610 includes a p-channel metal-oxide semiconductor (PMOS) transistor 620 and an n-channel metal-oxide semiconductor (NMOS) transistor 630 that are connected between a power supply terminal Vdd and a ground terminal. The CMOS transistor 610 may include one of the semiconductor devices 100 and 200 of the embodiments described with reference to FIGS. 1 to 4 and 6A to 11F, or a combination of modifications of the semiconductor devices 100 and 200.

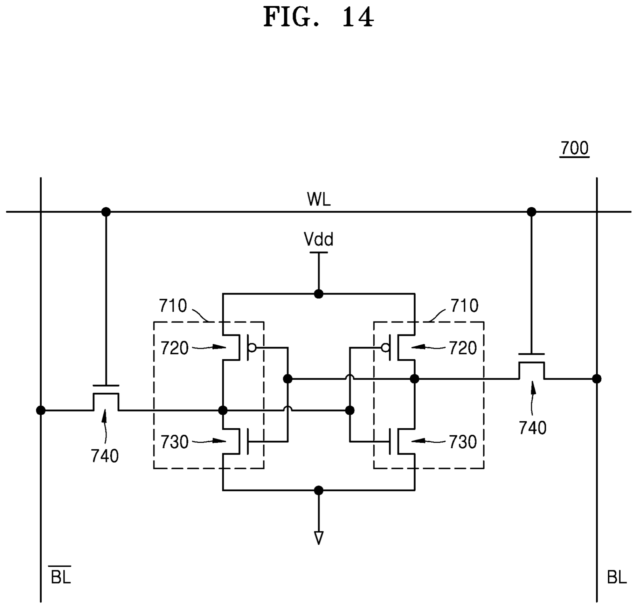

FIG. 14 is a circuit diagram illustrating a CMOS SRAM device 700 according to an embodiment.

Referring to 14, the CMOS SRAM device 700 includes a pair of driving transistors 710. Each of the pair of driving transistors 710 includes a PMOS transistor 720 and an NMOS transistor 730 that are connected between a power supply terminal Vdd and a ground terminal. The CMOS SRAM device 700 may further include a pair of transfer transistors 740. A source of each of the pair of transfer transistors 740 is cross-connected to a common node of the PMOS transistor 720 and the NMOS transistor 730 of each of the pair of driving transistors 710. A source of the PMOS transistor 720 is connected to the power supply terminal Vdd, and a source of the NMOS transistor 730 is connected to the ground terminal. Gates of the pair of transfer transistors 740 may be connected to a word line WL, and drains of the pair of transfer transistors 740 may be respectively connected to a bit line BL and an inverted bit line. At least one of the pair of driving transistors 710 and the pair of transfer transistors 740 of the CMOS SRAM device 700 may include one of the semiconductor devices 100 and 200 of the embodiments described with reference to FIGS. 1 to 4 and 6A to 11F, or a combination of modifications of the semiconductor devices 100 and 200.

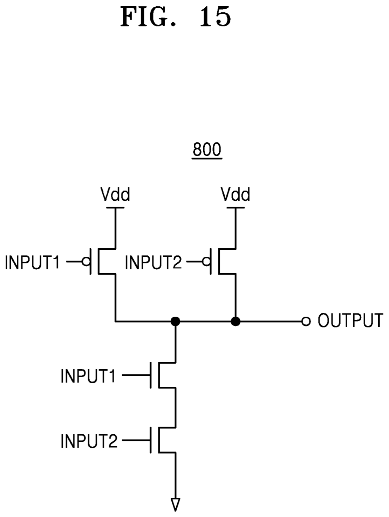

FIG. 15 is a circuit diagram of a CMOS NAND circuit 800 according to an embodiment.

Referring to 15, the CMOS NAND circuit 800 includes a pair of CMOS transistors receiving different input signals. The CMOS NAND circuit 800 may include one of the semiconductor devices 100 and 200 of the embodiments described with reference to FIGS. 1 to 4 and 6A to 11F, or a combination of modifications of the semiconductor devices 100 and 200.

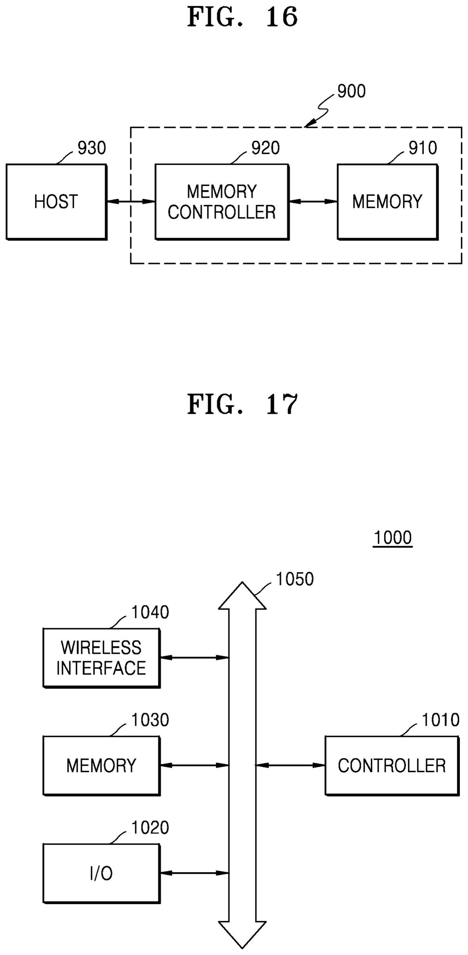

FIG. 16 is a block diagram illustrating an electronic apparatus 900 according to an embodiment.

Referring to 16, the electronic apparatus 900 includes memory 910 and a memory controller 920. The memory controller 920 may control the memory 910 to read data from and/or write data to the memory 910 in response to requests from a host 930. At least one of the memory 910 and the memory controller 920 may include one of the semiconductor devices 100 and 200 of the embodiments described with reference to FIGS. 1 to 4 and 6A to 11F, or a combination of modifications of the semiconductor devices 100 and 200.

FIG. 17 is a block diagram illustrating an electronic apparatus 1000 according to an embodiment.

Referring to FIG. 17, the electronic apparatus 1000 may form a wireless communication device or a device capable of transmitting and/or receiving information in a wireless environment. The electronic apparatus 1000 includes a controller 1010, an input/output (I/O) device 1020, memory 1030, and a wireless interface 1040 that are connected to each other via a bus 1050.

The controller 1010 may include at least one selected from a microprocessor, a digital signal processor, and a similar processing device. The I/O device 1020 may include at least one selected from a keypad, a keyboard, and a display. The memory 1030 may store instructions executed by the controller 1010. For example, the memory 1030 may store user data. The electronic apparatus 1000 may use the wireless interface 1040 to transmit/receive data over a wireless communication network. The wireless interface 1040 may include an antenna and/or a wireless transceiver. In some embodiments, the electronic apparatus 1000 may be used with communication interface protocols of third-generation communication systems such as code division multiple access (CDMA), global system for mobile communications (GSM), North American digital cellular (NADC), extended-time division multiple access (E-TDMA), and/or wideband code division multiple access (WCDMA). The electronic apparatus 1000 may include one of the semiconductor devices 100 and 200 of the embodiments described with reference to FIGS. 1 to 4 and 6A to 11F, or a combination of modifications of the semiconductor devices 100 and 200.

As described above, according to one or more of the embodiments described above, the semiconductor devices include a two-dimensional semiconductor channel that experiences substantially no damage during manufacturing, thereby improving electrical performance.

The semiconductor devices may be used not only as planar FETs but also as GAA FETs and may be applied to various electronic apparatuses as logic transistors.

The manufacturing methods of the embodiments may provide semiconductor devices with low damage to a two-dimensional semiconductor material.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a first insulating layer; and
a channel formation layer on the first insulating layer and including a two-dimensional semiconductor material, wherein
the channel formation layer comprises
an active semiconductor layer bonded to an upper surface of the first insulating layer with a first adhesion energy, and
an inactive semiconductor layer laterally bonded to the active semiconductor layer,
the inactive semiconductor layer comprises an element included in the active semiconductor layer,
the inactive semiconductor layer is bonded to the upper surface of the first insulating layer with a second adhesion energy, and
the second adhesion energy is greater than the first adhesion energy.

2. The semiconductor device of claim 1, wherein the active semiconductor layer is Van der Waals bonded to the upper surface of the first insulating layer
and/or
wherein
the inactive semiconductor layer has a structure in which a material forming the active semiconductor layer is oxidized, nitrided, or amorphized.

3. The semiconductor device of claim 1 or 2, wherein the active semiconductor layer comprises a transition metal dichalcogenide (TMD) material,
in particular,
wherein
the inactive semiconductor layer comprises a transition metal and a chalcogen element that are included in the TMD material, and
the inactive semiconductor layer further comprises oxygen or nitrogen.

4. The semiconductor device of one of the previous claims, further comprising:
a second insulating layer on the active semiconductor layer;
a source electrode electrically connected to a first end of the active semiconductor layer;
a drain electrode electrically connected to a second end of the active semiconductor layer; and
an upper gate electrode on the second insulating layer.

5. The semiconductor device of claim 4, further comprising:
a lower gate electrode under the first insulating layer.

6. The semiconductor device of claim 5, wherein
the upper gate electrode and the lower gate electrode each include an active gate region and an inactive gate region,
the inactive gate region of the upper gate electrode faces the inactive semiconductor layer, and
the inactive gate region of the lower gate electrode faces the inactive semiconductor layer.

7. The semiconductor device of claim 6, wherein
in the upper gate electrode and the lower gate electrode, the inactive gate region has a structure in which a conductive material included in the active gate region is insulated.

8. An electronic apparatus comprising:
a semiconductor device according to one of the previous claims; and
a controller configured to control the semiconductor device.

9. A method of manufacturing a semiconductor device, the method comprising:
forming a two-dimensional semiconductor material layer on a first insulating layer,
the two-dimensional semiconductor material layer comprising a two-dimensional semiconductor material, and
the first insulating layer comprising an insulating material; and
forming a channel formation layer comprising an inactive semiconductor layer and an active semiconductor layer by irradiating a portion of the two-dimensional semiconductor material layer with a plasma or an ion beam.

10. The method of claim 9, wherein
the two-dimensional semiconductor material layer is bonded to the first insulating layer with a first adhesion energy,
the inactive semiconductor layer is bonded to the first insulating layer with a second adhesion energy, and
the second adhesion energy is greater than the first adhesion energy.

11. The method of claim 9 or 10, further comprising:
prior to the forming the channel formation layer, forming a second insulating layer on the two-dimensional semiconductor material layer,
in particular,
wherein the second insulating layer has a thickness of 5 nm or less.

12. The method of claim 11, further comprising:
forming a gate electrode on a region of the second insulating layer that overlaps the active semiconductor layer.

13. The method of one of claims 9 to 12, wherein
the forming the channel formation layer comprises arranging a mask layer on the two-dimensional semiconductor material layer, and
the mask layer exposes a portion of the two-dimensional semiconductor material layer,
in particular,
wherein the mask layer comprises a photoresist material, an electron-beam (e-beam) resist material, or a metal material.

14. The method of one of claims 9 to 13, wherein the method further comprises:
prior to the forming the channel formation layer, forming a first conductive layer and a second conductive layer on a lower side of the two-dimensional semiconductor material layer and an upper side of the two-dimensional semiconductor material layer, respectively.

15. The method of claim 14, wherein
in the forming the channel formation layer, a region of the first conductive layer is electrically inactivated and a region of the second conductive layer is electrically inactivated to provide an electrically inactivated region of the first conductive layer and an electrically inactivated region of the second conductive layer,
in particular,
wherein the electrically inactivated region of the first conductive layer and the electrically inactivated region of the second conductive layer face each other with the inactive semiconductor layer therebetween.
